(19) Europäisches Patentamt
European Patent Office
Office européen des brevets

(11) **EP 4 512 942 A1**

(12) **EUROPEAN PATENT APPLICATION**
published in accordance with Art. 153(4) EPC

(43) Date of publication:
**26.02.2025 Bulletin 2025/09**

(21) Application number: **23791794.3**

(22) Date of filing: **14.04.2023**

(51) International Patent Classification (IPC):
**C30B 29/06** (2006.01)    **C03B 20/00** (2006.01)
**C30B 15/10** (2006.01)

(52) Cooperative Patent Classification (CPC):
**C03B 20/00; C30B 15/10; C30B 29/06**

(86) International application number:
**PCT/JP2023/015114**

(87) International publication number:
**WO 2023/204146 (26.10.2023 Gazette 2023/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.04.2022  JP 2022068517**

(71) Applicant: **Shin-Etsu Quartz Products Co., Ltd.
Tokyo 141-0032 (JP)**

(72) Inventor: **ISHIHARA, Yu
Echizen-shi, Fukui 915-8535 (JP)**

(74) Representative: **Sonnenhauser, Thomas Martin
Wuesthoff & Wuesthoff
Patentanwälte und Rechtsanwalt PartG mbB
Schweigerstraße 2
81541 München (DE)**

(54) **QUARTZ GLASS CRUCIBLE FOR PULLING UP MONOCRYSTALLINE SILICON INGOT**

(57)    The present invention is a quartz glass crucible for pulling a single crystal silicon ingot, the crucible having a crucible shape including a straight body portion, a curved portion, and a bottom portion. The crucible includes: an outer layer made of an opaque quartz glass containing bubbles; and an inner layer made of a transparent quartz glass and having a thickness of greater than or equal to 1.5 mm. Concentrations of Na, K, and Li in the inner layer at 1 mm from an inner surface of the quartz glass crucible are less than 5 ppb by mass for Na, less than 5 ppb by mass for K, and less than 100 ppb by mass for Li. Average concentrations of Na, K, and Li in a thickness direction at the curved portion and the bottom portion in the outer layer are less than 10 ppb by mass for Na, less than 50 ppb by mass for K, and less than 180 ppb by mass for Li. This provides a quartz glass crucible for pulling a single crystal silicon ingot that can inhibit pinholes in pulled-up single crystal silicon ingots.

[FIG. 1]

**Description**

TECHNICAL FIELD

The present invention relates to a quartz glass crucible for pulling a single crystal silicon ingot.

BACKGROUND ART

A so-called Czochralski method ("CZ method") has been widely used for manufacturing single crystal silicon (single crystal silicon ingots). In the CZ method, a silicon melt is placed in a quartz glass crucible, and a seed crystal is brought into contact with the surface of the silicon melt. The quartz glass crucible is then rotated, and the seed crystal is pulled upward while being rotated in the opposite direction, thereby causing single crystal silicon to grow at the lower end of the seed crystal.

Single crystal silicon ingots manufactured using a quartz glass crucible may contain bubbles of several micrometers to several millimeters in size, called pinholes. Silicon wafers containing these bubbles can be detected by visual or infrared inspection, but the presence of even a single pinhole causes a yield reduction.

The bubbles that cause pinholes in pulled single crystal silicon ingots originate from, for example, gasses inside the pulling apparatus, bubbles contained in the inner surface of the quartz glass crucible, and gases generated by the reaction between the silicon melt and the quartz glass crucible, and measures have been taken against these bubbles (e.g., Patent Document 1).

CITATION LIST

PATENT LITERATURE

Patent Document 1: WO2013/140706 A1

SUMMARY OF INVENTION

TECHNICAL PROBLEM

As described above, measures have been taken against the bubbles that cause pinholes in pulled single crystal silicon ingots. However, there are cases where pinholes occur that cannot be accounted for by these bubbles alone, and a need has existed for a quartz glass crucible that creates fewer pinholes in pulled single crystal silicon ingots.

The present invention has been made to solve the above problem. An object of the present invention is to provide a quartz glass crucible for pulling a single crystal silicon ingot that can inhibit pinholes in pulled single crystal silicon ingots.

SOLUTION TO PROBLEM

The present invention has been made to solve the above problem, and provides a quartz glass crucible for pulling a single crystal silicon ingot, the crucible having a crucible shape including a straight body portion, a curved portion, and a bottom portion. The crucible includes: an outer layer made of an opaque quartz glass containing bubbles; and an inner layer made of a transparent quartz glass and having a thickness of greater than or equal to 1.5 mm. Concentrations of Na, K, and Li in the inner layer at 1 mm from an inner surface of the quartz glass crucible are less than 5 ppb by mass for Na, less than 5 ppb by mass for K, and less than 100 ppb by mass for Li. Average concentrations of Na, K, and Li in a thickness direction at the curved portion and the bottom portion in the outer layer are less than 10 ppb by mass for Na, less than 50 ppb by mass for K, and less than 180 ppb by mass for Li.

Such a quartz glass crucible can facilitate depth-wise crystallization in brown rings that are formed on the inner surface of the quartz glass crucible during pulling of single crystal silicon ingots. This can inhibit the release of bubbles formed inside the brown rings, thereby inhibiting pinholes in the pulled single crystal silicon ingots.

Preferably, concentrations of Na, K, and Li in the inner layer at 1 mm from the inner surface of the quartz glass crucible are less than 5 ppb by mass for Na, less than 5 ppb by mass for K, and less than 50 ppb by mass for Li, and average concentrations of Na, K, and Li in the thickness direction at the curved portion and the bottom portion in the outer layer are less than 5 ppb by mass for Na, less than 50 ppb by mass for K, and less than 100 ppb by mass for Li.

By satisfying these concentrations of impurity elements (hereinafter, Na, K, and Li may be referred to collectively as impurity elements) in the inner and outer layers of the quartz glass crucible, pinholes in the pulled single crystal silicon ingots can be more effectively inhibited.

Preferably, average concentrations of Na, K, and Li in the thickness direction at the straight body portion in the outer layer satisfy at least one of: greater than or equal to 10 ppb by mass for Na; greater than or equal to 50 ppb by mass for K; and greater than or equal to 180 ppb by mass for Li.

By satisfying these impurity concentrations at the straight body portion in the outer layer, collapsing and sinking of the quartz glass crucible during high-temperature heating can be inhibited, rather than by making the entire crucible highly pure.

An outer diameter of the quartz glass crucible may be greater than or equal to 800 mm.

The present invention can be suitably applied to such quartz glass crucibles with a diameter of as large as greater than or equal to 800 mm.

Preferably, the quartz glass crucible holds a silicon melt therein, and has a brown ring formed on the inner surface thereof after pulling a single crystal silicon ingot from the silicon melt, and a density of bubbles with a diameter of greater than or equal to 3.0 um in the inner layer within an inner region of the brown ring is greater than or equal to 4.0 bubbles/mm$^2$.

The quartz glass crucible having such brown rings formed on the inner surface thereof after pulling single crystal silicon ingots can more effectively inhibit pinholes on the pulled single crystal silicon ingots.

Preferably, the quartz glass crucible holds a silicon melt therein, and has a brown ring formed on the inner surface thereof after pulling a single crystal silicon ingot from the silicon melt, the brown ring having an outer diameter reference line with a length of from 10 mm to 13 mm, the outer diameter reference line of the brown ring being defined as a bisecting line extending along a circumferential direction of the quartz glass crucible, and the brown ring having the outer diameter reference line with the length of from 10 mm to 13 mm satisfies the following formula (1):

$$y \geq 10x - 70 \quad \ldots \quad (1)$$

where the length of the outer diameter reference line of the brown ring is defined as x [mm], an uppermost portion at an end of the outer diameter reference line of the brown ring is defined as a reference height 0 [pm], and a protrusion height, which is a height of an uppermost portion on the outer diameter reference line in an inner region of the brown ring, is defined as y [pm].

The quartz glass crucible having such brown rings formed can more effectively inhibit pinholes on the pulled single crystal silicon ingots as well.

ADVANTAGEOUS EFFECTS OF INVENTION

The inventive quartz glass crucible can facilitate the crystallization in the depth direction of brown rings during pulling of single crystal silicon ingots. This can inhibit the release of bubbles formed inside the brown rings, thereby inhibiting pinholes in the pulled single crystal silicon ingots.

BRIEF DESCRIPTION OF DRAWINGS

FIG. 1 is a schematic sectional view showing portions of a typical quartz glass crucible;
FIG. 2 is a picture of brown rings formed on an inner surface of the quartz glass crucible;
FIG. 3 is a graph showing diameters of bubbles inside a brown ring;
FIG. 4 is a graph showing relationship between the Li concentration in an inner layer of the quartz glass crucible and the bubble density inside a brown ring;
FIG. 5 is a graph showing correlation between the Na concentration in an outer layer of the quartz glass crucible and the Na concentration in the inner layer of the quartz glass crucible;
FIG. 6 is a graph showing correlation between the K concentration in the outer layer of the quartz glass crucible and the K concentration in the inner layer of the quartz glass crucible;
FIG. 7 is a graph showing correlation between the Li concentration in the outer layer of the quartz glass crucible and the Li concentration in the inner layer of the quartz glass crucible;
FIG. 8 is a graph showing the topography of brown rings in Experimental Examples 1 to 4; and
FIG. 9 is a schematic view of a brown ring.

DESCRIPTION OF EMBODIMENTS

As described above, measures have been taken against the bubbles that cause pinholes. However, there are cases where pinholes occur that cannot be accounted for by these bubbles alone, and the present inventor has tried to solve it.

Brownish-red rings, called brown rings, are formed on the inner surface of a quartz glass crucible after pulling single crystal silicon ingots. A detailed investigation of these brown rings revealed that the brown rings contain bubbles of several to several tens of micrometers in diameter, and these bubbles were expected to become pinholes by being exposed to the silicon melt.

As described above, bubbles of several to several tens of micrometers in size are present inside the brown rings. An investigation by the present inventor revealed that lowering the Na, K, and Li concentrations in the inner layer of the quartz glass crucible can reduce the diameter of the bubbles inside the brown rings, and can also facilitate depth-wise crystallization inside the brown rings, thereby reducing erosion into the silicon melt. In other words, it is possible to inhibit the release of bubbles inside the brown rings into the silicon melt, thereby reducing the number of bubbles incorporated into single crystal silicon ingots and reducing the number of pinhole defects in silicon wafers.

The present invention is described in greater detail below. The present invention is a quartz glass crucible for pulling a single crystal silicon ingot, the crucible having a crucible shape including a straight body portion, a curved portion, and a bottom portion. The crucible includes: an outer layer made of an opaque quartz glass containing bubbles; and an inner layer made of a transparent quartz glass and having a thickness of greater than or equal to 1.5 mm. Concentrations of Na, K, and Li in the inner layer at 1 mm from an inner surface of the quartz glass crucible are less than 5 ppb by mass for Na, less than 5 ppb by mass for K, and less than 100 ppb by mass for Li, and average concentrations of Na, K, and Li in a thickness direction at the curved portion and the bottom portion in the outer layer are less than 10 ppb by mass for Na, less than 50 ppb by mass for K, and less than 180 ppb by mass for Li. These requirements need to be satisfied before pulling a single crystal silicon ingot.

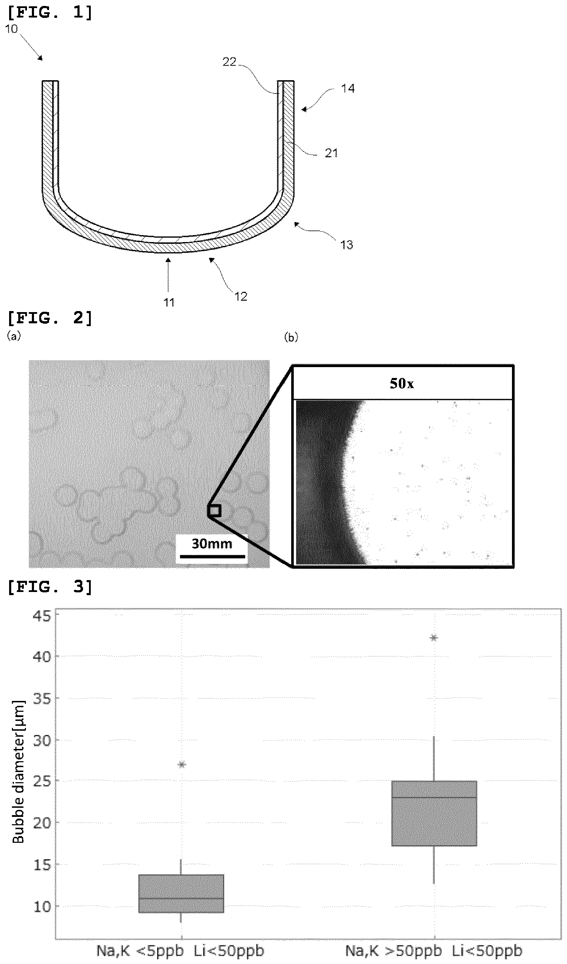

Referring first to FIG. 1, portions of the inventive quartz glass crucible are described. The quartz glass crucible 10 in FIG. 1 includes an outer layer 21 made of an opaque quartz glass containing bubbles and an inner layer 22 made of a transparent quartz glass. As shown in FIG. 1, the crucible shape of the quartz glass crucible 10 typically consists of a bottom portion 12, a curved portion 13, and a straight body portion 14. A bottom center 11 is defined at the center of the bottom portion 12, and the bottom portion 12 and the curved portion 13 are sometimes referred to as a large-curved portion and a small-curved portion, respectively.

As described above, in the inventive quartz glass crucible 10, concentrations of Na, K, and Li in the inner layer 22, which has a thickness of greater than or equal to 1.5 mm, at 1 mm from the quartz glass crucible inner surface are less than 5 ppb by mass for Na, less than 5 ppb by mass for K, and less than 100 ppb by mass for Li. Such high purity of the inner layer 22 of the quartz glass crucible 10 satisfying the above Na, K, and Li concentration requirements can facilitate crystallization in the depth direction of brown rings during pulling of single crystal silicon ingots. This, in turn, can inhibit the release of bubbles formed inside the brown rings. Also, in the inventive quartz glass crucible 10, average concentrations of Na, K, and Li in the thickness direction at the curved portion 13 and the bottom portion 12 in the outer layer 21 are less than 10 ppb by mass for Na, less than 50 ppb by mass for K, and less than 180 ppb by mass for Li. By satisfying these element concentrations at the curved portion 13 and the bottom portion 12 in the outer layer 21, the diffusion of the above impurity elements to the crucible inner surface can be inhibited, making it possible to maintain the crucible inner layer 22 at a high purity.

The above impurity concentrations are preferably made to provide higher purity as follows. That is, the concentrations of Na, K, and Li in the inner layer 22 at 1 mm from the quartz glass crucible inner surface are preferably less than 5 ppb by mass for Na, less than 5 ppb by mass for K, and less than 50 ppb by mass for Li. The average concentrations of Na, K, and Li in the thickness direction at the curved portion 13 and the bottom portion 12 in the outer layer 21 are preferably less than 5 ppb by mass for Na, less than 50 ppb by mass for K, and less than 100 ppb by mass for Li. By satisfying these impurity element concentrations, pinholes in the pulled single crystal silicon ingots can be more effectively inhibited.

The impurity element concentrations in each layer of the inventive quartz glass crucible can be measured by preparing samples from the quartz glass crucible 10 and using an inductively coupled plasma-mass spectrometry (ICP-MS) method or the like. For both the inner layer 22 and the outer layer 21, the measurement points shall include at least one point in each of the straight body portion 14, the curved portion 13, and the bottom portion 12. Two or more measurement points may be set in each portion to take an average value.

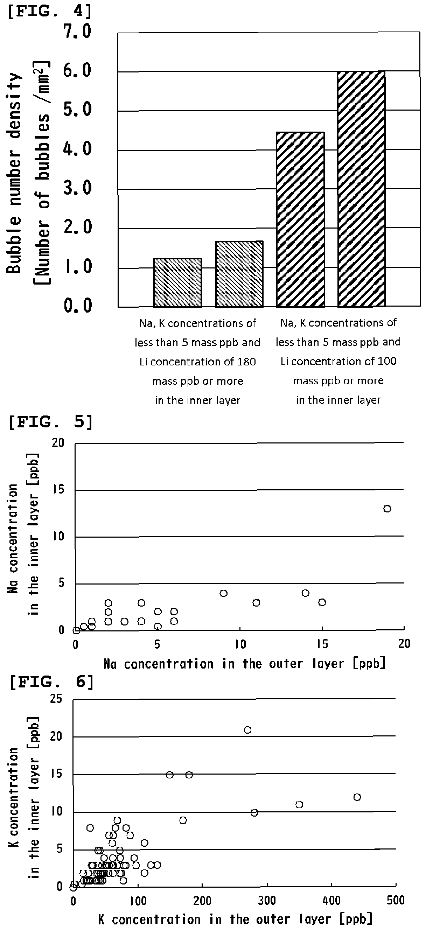

The diffusion of each impurity element between the outer layer 21 and the inner layer 22 is described with reference to FIGS. 5 through 7. FIGS. 5 through 7 show the correlations between the concentration in the outer layer 21 of the quartz glass crucible (average concentration in the crucible thickness direction) and the concentration in the inner layer 22 of the quartz glass crucible (concentration at 1 mm from the inner surface of the quartz glass crucible 10) for Na, K, and Li, respectively. The correlations shown in these figures were measured by fabricating a quartz glass crucible 10 with an outer diameter of 32 inches (800 mm) and preparing samples from this quartz glass crucible. As can be seen from these figures, if the Na concentration is less than 10 ppb by mass in the outer layer 21, it can be less than 5 ppb by mass in the inner layer 22, if the K concentration is less than 50 ppb by mass in the outer layer 21, it can be less than 5 ppb by mass in the inner layer 22, and if the Li concentration is less than 180 ppb by mass in the outer layer 21, it can be less than 100 ppb by mass in the inner layer 22.

On the other hand, in the inventive quartz glass crucible 10, average concentrations of Na, K, and Li in the thickness direction at the straight body portion 14 in the outer layer 21 preferably satisfy at least one of: greater than or equal to 10 ppb by mass for Na; greater than or equal to 50 ppb by mass for K; and greater than or equal to 180 ppb by mass for Li. To inhibit the quartz glass crucible 10 from collapsing or sinking inward during high-temperature heating, it is preferred to set the lower limits of the impurity element concentrations in the straight body portion 14 as described above. However, the inner layer 22 of the quartz glass crucible 10 needs to satisfy the above high purity requirements. Therefore, in order to prevent the inner layer 22 from being contaminated by diffusion, it is preferred not to increase the impurity element concentrations at the straight body portion 14 in the outer layer 21 beyond what is necessary.

The reason for providing separate requirements for the bottom and curved portions 12, 13 and the straight body portion 14 in the outer layer 21 in the above manner is that the bottom and curved portions 12, 13 of the quartz glass crucible, in particular, have a longer contact time with the silicon melt and so the diameter of the brown rings tends to increase compared to those in the straight body portion 14. Hence, by lowering the Na, K, and Li concentrations in, in particular, the inner surface of the bottom and curved portions 12, 13 to facilitate the crystallization in the depth direction of the brown rings, it is possible to inhibit the release of bubbles formed inside the brown rings. In addition, by lowering the Na, K, and Li concentrations in the outer layer 21 only at the bottom and curved portions 12, 13, it is possible to inhibit pinhole defects while inhibiting deformation of the straight body portion 14 during use of the quartz glass crucible 10.

The present invention can be suitably applied to quartz glass crucibles 10 with an outer dimeter of 800 mm or greater. Such quartz glass crucibles 10 can pull larger-diameter single crystal silicon ingots, and even such larger-diameter single crystal silicon ingots can be pulled with fewer pinholes formed therein. Single crystal silicon wafers with a diameter of 12 inches (300 mm) or greater have strict specifications about pinholes, and quartz glass crucibles with an outer diameter of 800 mm or greater used for such wafers also have high quality requirements. In such cases, both the single crystal silicon wafers and the quartz glass crucible are large, and bubbles are likely to be caught on the underside of the pulled single crystal silicon ingots. Thus, the application of the present technique is necessary.

The relationship between the conditions of brown rings on the surface of the inner layer of the quartz glass crucible and the impurity element concentrations in the quartz glass crucible inner layer is described below.

As described above, brown-colored rings called "brown rings" are formed on the quartz glass crucible inner surface due to contact with the silicon melt, and bubbles of several to several tens of micrometers in size were found to be observed inside the ring. Comparing cases where Na and K concentrations in the inner layer of the quartz glass crucible are both less than 5 ppb by mass and where the Na and K concentrations are both greater than or equal to 50 ppb by mass, the bubbles were found to be smaller in diameter if the Na and K concentrations are less than 5 ppb by mass.

FIG. 2 shows a picture of brown rings formed on the quartz glass crucible inner surface. FIG. 2(a) shows the quartz glass crucible inner surface. The circular objects appearing in FIG. 2(a) are brown rings. Brown rings may be isolated, but as shown in FIG. 2(a), some brown rings may be joined together. FIG. 2(b) is an enlarged view of a portion in FIG. 2(a). As shown in FIG. 2(b), bubbles of several to several tens of micrometers in size are observed inside a brown ring.

FIG. 3 shows the results of investigation on the diameter of the bubbles inside the brown ring shown in FIG. 2(b). FIG. 3 shows the comparison between cases where the impurity element concentrations in the quartz glass crucible inner layer are less than 5 ppb by mass for both Na and K and less than 50 ppb by mass for Li and where the impurity element concentrations are greater than 50 ppb by mass for both Na and K and less than 50 ppb by mass for Li. As can be seen from this figure, at the same Li concentration of less than 50 ppb by mass, the bubble diameter is smaller when both the Na and K concentrations are less than 5 ppb by mass.

As shown in FIG. 4, comparing cases where the Li concentration in the quartz glass crucible inner layer is greater than or equal to 180 ppb by mass and where the Li concentration is less than 100 ppb by mass, the number density of bubbles near the center of the brown ring was found to be higher at the Li concentration of less than 100 ppb by mass. A high number density of bubbles means that the bubbles remain unreleased. In that case, the bubbles are present at deep positions and have not been incorporated into the silicon melt.

In addition to the above findings, it was also found that fewer pinholes of several to several tens of micrometers in size are formed in pulled single crystal silicon ingots if the quartz glass crucible inner layer has the Na and K concentrations of less than 5 ppb by mass and the Li concentration of less than 100 ppb by mass.

From the above, the occurrence of pinholes in pulled single crystal silicon ingots can presumably be reduced by lowering the Na and K concentrations in the inner layer of the quartz glass crucible to reduce the bubble diameter and by lowering the Li concentration to inhibit the release of bubbles into the silicon melt. To summarize the effects of the inventive requirements for impurity elements, an advantage of lowering the Na and K concentrations is that the bubbles inside the brown rings can be kept small by lowering the Na and K concentrations. Advantages of lowering the Li concentration are that the crystallization in the depth direction of the brown rings can occur at a faster rate and that, as a result of this, the bubbles forced to occur by the crystallization can be made present at relatively deeper positions, and also the crystallization slows down the erosion rate, preventing the bubbles from being released into the silicon melt.

As described above, brown rings are formed due to the crystallization of the inner surface of the quartz glass crucible, so it was presumed that the degree of crystallization varies depending on the Na, K, and Li concentrations in the inner surface of the quartz glass crucible and that the lower the N, K, and Li concentrations, the more the crystallization inside the brown rings, or in other words, the crystallization in the depth direction from the inner surface of the quartz glass crucible progresses, thereby reducing the erosion into the silicon melt. Hence, as shown in the following experimental examples, the topography of 12-mm diameter brown rings formed on quartz glass crucibles with different inner surface Na, K, and Li concentrations were measured using a surface roughness measuring instrument.

Experimental Examples 1 to 4

Four types of quartz glass crucibles with different inner surface Na, K, and Li concentrations were prepared. The impurity element concentrations at 1 mm deep from the inner surface of each quartz glass crucible were as follows:

Experimental Example 1 ... Na: 3 ppb by mass, K: 1 ppb by mass, Li: 200 ppb by mass
Experimental Example 2 ... Na: 2 ppb by mass, K: 3 ppb by mass, Li: 200 ppb by mass
Experimental Example 3 ... Na: 3 ppb by mass, K: 2 ppb by mass, Li: 70 ppb by mass
Experimental Example 4 ... Na: 4 ppb by mass, K: 1 ppb by mass, Li: 70 ppb by mass

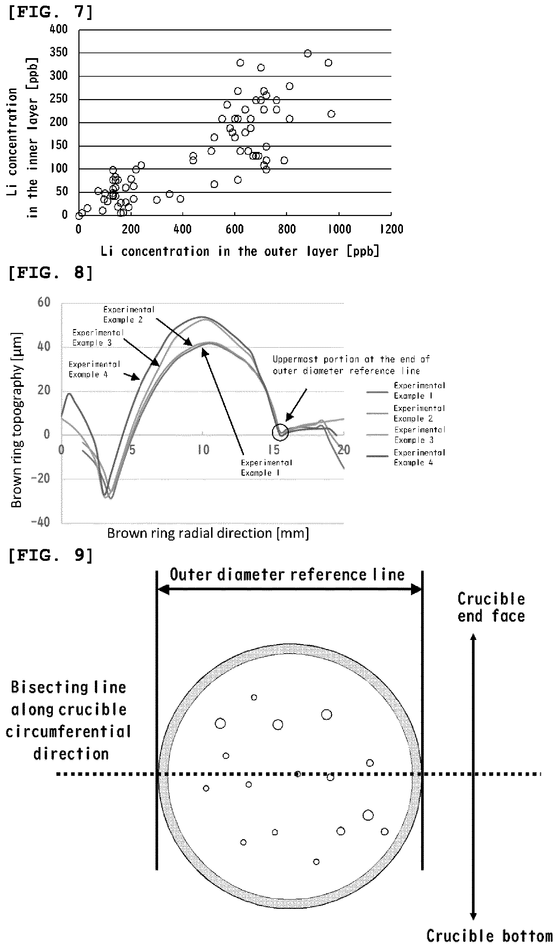

The topography of 12-mm diameter brown rings formed on these quartz glass crucibles with different inner layer Na, K, and Li concentrations was measured using a surface roughness measuring instrument. The results were as shown in FIG. 8.

As can be seen from FIG. 8, when the Na and K concentrations are both less than 5 ppb by mass and the Li concentration is less than 100 ppb by mass in the quartz glass crucible inner layer (Experimental Examples 3 and 4), protrusions are about 10 to 20 um higher than when the Na and K concentrations are both less than 5 ppb by mass and the Li concentration is greater than or equal to 100 ppb by mass (Experimental Examples 1 and 2). In other words, it can be said that when the Na and K concentrations are both less than 5 ppb by mass and the Li concentration is less than 100 ppb by mass, the crystallization inside the brown rings is facilitated, inhibiting the erosion into the silicon melt. This erosion difference of 10 to 20 um is believed to be affecting the release of bubbles of several to several tens of micrometers in size.

A high alkali metal content generally facilitates the crystallization of quartz glass. However, it can be said that the opposite phenomenon is occurring inside the brown rings, which are formed by the reaction between the quartz glass with low metal concentrations and the silicon melt. From this, keeping the impurity element concentrations in the inner layer of the quartz glass crucible at less than 5 ppb by mass for Na, less than 5 ppb by mass for K, and less than 100 ppb by mass for Li can presumably facilitate the crystallization inside the brown rings, thereby inhibiting the bubbles inside the brown rings from being exposed.

As described above, quartz glass crucibles that satisfy the inventive requirements for impurity element concentrations can facilitate the crystallization in the depth direction of brown rings during pulling of single crystal silicon ingots. As a result, the inventive quartz glass crucible can be defined as follows, based on the brown ring after pulling a single crystal silicon ingot. That is, the inventive quartz glass crucible holds a silicon melt therein and has a brown ring formed on the inner surface thereof after pulling a single crystal silicon ingot from the silicon melt, and, preferably, a density of bubbles with a diameter of greater than or equal to 3.0 um in the inner layer within an inner region of the brown ring is greater than or equal to 4.0 bubbles/mm$^2$. The quartz glass crucible having such brown rings formed on the inner surface thereof after pulling single crystal silicon ingots can more effectively inhibit pinholes in the pulled single crystal silicon ingots.

A multi-pulling method, in which multiple single crystal silicon ingots are pulled up from a single quartz glass crucible, is increasingly used, and the above definition of the inventive quartz glass crucible based on bubbles in the brown ring after the pulling shall be the one that defines the quartz glass crucible after pulling the first single crystal silicon ingot. Here, the quartz glass crucible is used for about tens to a hundred hours. This is because, in the case of pulling multiple ingots, the brown rings that once occurred may disappear in the course of prolonged usage.

The inventive quartz glass crucible holds a silicon melt therein and has a brown ring formed on the inner surface thereof after pulling a single crystal silicon ingot from the silicon melt, and, preferably, a protrusion height of the brown ring satisfies the following requirements. That is, preferably, a brown ring having an outer diameter reference line with a length of from 10 mm to 13 mm is formed, where the outer diameter reference line of the brown ring is defined as a bisecting line of the brown ring extending along a circumferential direction of the quartz glass crucible. Also, preferably, the brown ring having the outer diameter reference line with the length of from 10 mm to 13 mm satisfies the following formula (1):

$$y \geq 10x - 70 \quad ... \quad (1)$$

where the length of the outer diameter reference line of the brown ring is defined as x [mm], an uppermost portion at an end of the outer diameter reference line of the brown ring is defined as a reference height 0 [pm], and a protrusion height, which is a height of an uppermost portion on the outer diameter reference line in an inner region of the brown ring, is defined as y [pm].

The quartz glass crucible having such brown rings formed can more effectively inhibit pinholes in the pulled single crystal silicon ingots as well.

A more detailed description is given below. FIG. 9 is a schematic view of a brown ring. The density of bubbles inside the brown ring as well as the outer diameter and reference height of the brown ring in the present invention pertain to a single brown ring as shown in FIG. 9. A union of multiple brown rings is not used for the calculation of these values.

In FIG. 9, a direction from the bottom portion of the quartz glass crucible to the end face thereof (upper end of the straight body portion), i.e., the vertical direction, is shown. The bisecting line extending along the circumferential direction of the crucible is a line that bisects the brown ring in a plane perpendicular to the vertical direction of the quartz glass crucible. The outer diameter reference line refers to a line segment between two points at which the bisecting line intersects the outer circumference of the brown ring. In the present invention, it is preferred that brown rings having the outer diameter reference line with the length of from 10 mm to 13 mm are formed after pulling the first single crystal silicon ingot. The outer diameter reference line can be said to be the outer diameter of the brown rings. However, since the brown rings are not always perfectly circular, the above definition is used.

The uppermost portion at the end of the outer diameter reference line of the brown ring is the higher of the above two points. This is described with reference to FIG. 8. FIG. 8 shows the height of the brown ring in FIG. 9 relative to the inner surface of the quartz glass crucible, as measured using a surface roughness measuring instrument. The uppermost portion at the end of the outer diameter reference line shown on the right side of FIG. 8 is defined as a reference height 0 [pm]. A protrusion height, which is the height of an uppermost portion on the outer diameter reference line in an inner region of the brown ring, is defined as y [um]. In Experimental Example 4 in FIG. 8, the length of the outer diameter reference line is approximately 12.2 mm. The reference height 0 [pm] is located at approximately 15.5 mm on the horizontal axis in the figure. Since this position is set as the reference height 0 [pm], the height of the uppermost portion on the outer diameter reference line, which is located at approximately 10 mm on the horizontal axis in the figure, is about 54 um. That is, y = 54, x = 12.2, satisfying the formula (1).

One presumable reason for this protruding profile of the brown ring to have occurred is that the crystallization progressed concurrently with the occurrence of erosion into the silicon melt and thus the crystallized portion avoided from the erosion, resulting in the protruding profile. In other words, the portion corresponding to the left side of the maximum value of the curve of each experimental example in FIG. 8 was presumably eroded by the flow of silicon melt, resulting most of the brown-colored portion (crystallized portion) disappearing.

Method for Manufacturing Quartz Glass Crucible

The inventive quartz glass crucible can be manufactured by any known method, except for controlling the impurity element concentrations in the inner and outer layers. For example, the inventive quartz glass crucible can be manufactured by a method called an arc rotating melting method. In this case, first, a silicon dioxide powder (silica powder, quartz powder) as a raw material powder is supplied into a rotating mold and molded by the centrifugal force into a crucible-like molded product. Then, the molded product has its inner side heated and melted by arc flames to form a translucent quartz glass crucible base (outer layer) (base forming step). During or after the formation of the crucible base, silicon dioxide powder is additionally supplied into the heated atmosphere inside the crucible base to form a transparent quartz glass inner layer on the inner surface of the crucible base (inner layer forming step). The method of forming the inner layer made of a transparent quartz glass by heating while scattering the quartz powder is also called a scattering method. The impurity element concentrations in the inner and outer layers can be adjusted, for example, by adjusting the impurity element concentrations in the raw material powder for each layer.

EXAMPLE

The present invention is now further detailed with reference to examples, though the present invention is not limited to these examples.

Examples 1 to 3 and Comparative Examples 1 to 4

Quartz glass crucibles with an outer diameter of 800 mm were manufactured using an arc rotating melting method. The impurity concentrations in the inner layer, the impurity concentrations in the outer layer (at the curved and bottom portions), and the impurity concentrations in the outer layer (at the straight body portion) of each manufactured quartz glass crucible were adjusted as shown in Table 1. That is, each impurity concentration shown in Table 1 is the concentration (unit: ppb by mass) in each portion of each quartz glass crucible prior to pulling a single crystal silicon ingot. As described above, the impurity concentration in the inner layer is the concentration at 1 mm deep from the inner surface of each quartz glass crucible, and the impurity concentration in each portion of the outer layer is the average concentration in the thickness direction.

Then, the manufactured quartz glass crucibles were used to pull single crystal silicon ingots. Brown rings formed on the inner surface of each quartz glass crucible after pulling the first single crystal silicon ingots were observed. Brown rings having the outer diameter reference line with the length of from 10 mm to 13 mm were selected as the brown rings to be observed. As the conditions of bubbles in the inner layer within the inner region of each brown ring, Table 2 shows the bubble diameter of the largest bubble among the bubbles contained and the density of bubbles with a diameter of greater than or equal to 3.0 um in the brown ring. Table 2 also shows the length x of the outer diameter reference line in the above formula (1) and the protrusion height y, which is the height of the uppermost portion on the outer diameter reference line, obtained by observing the brown rings. Table 2 also shows the conditions of pinholes that occurred after pulling the first single crystal silicon ingot, under the column "pinhole results." The pinhole results were evaluated on a three-level scale: "particularly good," "good," and "bad," which were defined as follows for convenience. In terms of the number of pinholes detected when fabricating single crystal silicon wafers from the single crystal silicon ingot, the pinhole results were evaluated as "bad" if the number of pinholes detected was greater than or equal to that of Comparative Example 1 as a reference, evaluated as "good" if the number of pinholes detected was less than or equal to half of that evaluated as "bad," and evaluated as "particularly good" if the number of pinholes detected was less than or equal to half of that evaluated as "good."

[Table 1]

| | Inner layer (1 mm deep from inner surface) [mass ppb] | | | Average concentrations in outer layer (at curved and bottom portions) [mass ppb] | | | Average concentrations in outer layer (at straight body portion) [mass ppb] | | |
|---|---|---|---|---|---|---|---|---|---|
| | Na | K | Li | Na | K | Li | Na | K | Li |
| Example 1 | 4 | <1 | 7 | 1 | 14 | 12 | 5 | 62 | 710 |
| Example 2 | <1 | 1 | 43 | 1 | 36 | 95 | 1 | 36 | 270 |
| Example 3 | 1 | 2 | 91 | 2 | 46 | 150 | 2 | 53 | 220 |
| Comparative Example 1 | 1 | 5 | 120 | 2 | 41 | 200 | 5 | 75 | 680 |
| Comparative Example 2 | 98 | 93 | 17 | 520 | 180 | 33 | 88 | 86 | 180 |
| Comparative Example 3 | 13 | 1 | 78 | 71 | 77 | 150 | 4 | 91 | 470 |
| Comparative Example 4 | 1 | 7 | 240 | 2 | 55 | 570 | 14 | 82 | 740 |

[Table 2]

| | Conditions of bubbles in brown rings | | Relative height of brown rings: formula(1) | | |
|---|---|---|---|---|---|
| | Maximum bubble diameter [$\mu$m] | Bubble density [Number of bubbles/mm$^2$] | Outer diameter reference line length [mm] | Uppermost portion height [$\mu$m] | Pinhole results |
| Example 1 | 13 | 5.5 | 10 | 34 | Particularly good |
| Example 2 | 11 | 4.2 | 11 | 45 | Particularly good |
| Example 3 | 11 | 4.8 | 12 | 52 | good |
| Comparative Example 1 | 23 | 1.4 | 12 | 42 | Bad |
| Comparative Example 2 | 25 | 1.6 | 10 | 25 | Bad |
| Comparative Example 3 | 20 | 1.5 | 10 | 20 | Bad |
| Comparative Example 4 | 25 | 1.3 | 11 | 32 | Bad |

As can be seen from Tables 1 and 2, the pinhole results were found to be good if the impurity concentrations of Na, K, and Li in the inner layer are less than 5 ppb by mass for Na, less than 5 ppb by mass for K, and less than 100 ppb by mass for Li, and the Na, K, and Li concentrations at the curved and bottom portions in the outer layer are less than 10 ppb for Na, less than 50 ppb by mass for K, and less than 180 ppb by mass for Li. In addition, with such impurity concentration requirements satisfied, the density of bubbles with a diameter of 3.0 um or greater in the brown ring was able to reach 4.0 bubbles/mm$^2$ or greater. Such a high number density means that the bubbles remain unreleased, and in that case, they are present at deep positions inside the brown ring and have not been incorporated into the silicon melt. As can be seen from Table 2, Examples 1 to 3 satisfied the above formula (1) for the brown rings having the outer diameter reference line with the length of from 10 mm to 13 mm, and in this case, the pinhole results were "particularly good" or "good." On the other hand, Comparative Examples 1 to 4 did not satisfy the above formula (1).

In each of the above examples and comparative examples, the impurity elements at the straight body portion in the outer layer of each manufactured quartz glass crucible included a high concentration element (satisfying at least one of greater than or equal to 10 ppb by mass for Na, greater than or equal to 50 ppb by mass for K, and greater than or equal to 180 ppb by mass for Li), which inhibited collapse and sinking.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1.    A quartz glass crucible for pulling a single crystal silicon ingot, the crucible having a crucible shape including a straight body portion, a curved portion, and a bottom portion, the crucible comprising:

      an outer layer made of an opaque quartz glass containing bubbles; and
      an inner layer made of a transparent quartz glass and having a thickness of greater than or equal to 1.5 mm, wherein
      concentrations of Na, K, and Li in the inner layer at 1 mm from an inner surface of the quartz glass crucible are less than 5 ppb by mass for Na, less than 5 ppb by mass for K, and less than 100 ppb by mass for Li, and
      average concentrations of Na, K, and Li in a thickness direction at the curved portion and the bottom portion in the outer layer are less than 10 ppb by mass for Na, less than 50 ppb by mass for K, and less than 180 ppb by mass for Li.

2.    The quartz glass crucible for pulling a single crystal silicon ingot according to claim 1, wherein

      concentrations of Na, K, and Li in the inner layer at 1 mm from the inner surface of the quartz glass crucible are less than 5 ppb by mass for Na, less than 5 ppb by mass for K, and less than 50 ppb by mass for Li, and
      average concentrations of Na, K, and Li in the thickness direction at the curved portion and the bottom portion in the outer layer are less than 5 ppb by mass for Na, less than 50 ppb by mass for K, and less than 100 ppb by mass for Li.

3.    The quartz glass crucible for pulling a single crystal silicon ingot according to claim 1 or 2, wherein average concentrations of Na, K, and Li in the thickness direction at the straight body portion in the outer layer satisfy at least one of: greater than or equal to 10 ppb by mass for Na; greater than or equal to 50 ppb by mass for K; and greater than or equal to 180 ppb by mass for Li.

4.    The quartz glass crucible for pulling a single crystal silicon ingot according to any one of claims 1 to 3, wherein an outer diameter of the quartz glass crucible is greater than or equal to 800 mm.

5.    The quartz glass crucible for pulling a single crystal silicon ingot according to any one of claims 1 to 4, wherein

      the quartz glass crucible holds a silicon melt therein, and has a brown ring formed on the inner surface thereof after pulling a single crystal silicon ingot from the silicon melt, and
      a density of bubbles with a diameter of greater than or equal to 3.0 um in the inner layer within an inner region of the brown ring is greater than or equal to 4.0 bubbles/mm$^2$.

6.    The quartz glass crucible for pulling a single crystal silicon ingot according to any one of claims 1 to 5, wherein

the quartz glass crucible holds a silicon melt therein, and has a brown ring formed on the inner surface thereof after pulling a single crystal silicon ingot from the silicon melt, the brown ring having an outer diameter reference line with a length of from 10 mm to 13 mm, the outer diameter reference line of the brown ring being defined as a bisecting line extending along a circumferential direction of the quartz glass crucible, and
the brown ring having the outer diameter reference line with the length of from 10 mm to 13 mm satisfies the following formula (1):

$$y \geq 10x - 70 \quad \ldots \quad (1)$$

where the length of the outer diameter reference line of the brown ring is defined as x [mm], an uppermost portion at an end of the outer diameter reference line of the brown ring is defined as a reference height 0 [pm], and a protrusion height, which is a height of an uppermost portion on the outer diameter reference line in an inner region of the brown ring, is defined as y [pm].

[FIG. 1]

[FIG. 2]

(a)

(b)

50x

30mm

[FIG. 3]

[FIG. 4]

Bubble number density [Number of bubbles /mm²]

Na, K concentrations of less than 5 mass ppb and Li concentration of 180 mass ppb or more in the inner layer

Na, K concentrations of less than 5 mass ppb and Li concentration of 100 mass ppb or more in the inner layer

[FIG. 5]

Na concentration in the inner layer [ppb]

Na concentration in the outer layer [ppb]

[FIG. 6]

K concentration in the inner layer [ppb]

K concentration in the outer layer [ppb]

[FIG. 7]

[FIG. 8]

[FIG. 9]

## INTERNATIONAL SEARCH REPORT

| International application No. |
| --- |
| **PCT/JP2023/015114** |

**A. CLASSIFICATION OF SUBJECT MATTER**

*C30B 29/06*(2006.01)i; *C03B 20/00*(2006.01)i; *C30B 15/10*(2006.01)i
FI: C30B29/06 502B; C03B20/00 H; C30B15/10

According to International Patent Classification (IPC) or to both national classification and IPC

**B. FIELDS SEARCHED**

Minimum documentation searched (classification system followed by classification symbols)

C30B29/06; C03B20/00; C30B15/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2019-119621 A (SUMCO CORP.) 22 July 2019 (2019-07-22)<br>entire text, all drawings | 1-6 |
| A | JP 2010-111524 A (SHINETSU QUARTZ PROD. CO., LTD.) 20 May 2010 (2010-05-20)<br>entire text, all drawings | 1-6 |
| A | JP 2003-95678 A (HERAEUS SHIN-ETSU AMERICA) 03 April 2003 (2003-04-03)<br>entire text, all drawings | 1-6 |
| A | WO 2010/137221 A1 (SHINETSU QUARTZ PROD. CO., LTD.) 02 December 2010 (2010-12-02)<br>entire text, all drawings | 1-6 |
| A | JP 2012-136379 A (COVALENT MATERIALS CORP.) 19 July 2012 (2012-07-19)<br>entire text, all drawings | 1-6 |
| A | JP 2020-100515 A (SUMCO CORP.) 02 July 2020 (2020-07-02)<br>entire text, all drawings | 1-6 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **16 June 2023** | **27 June 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/015114**

| Patent document cited in search report | | | Publication date (day/month/year) | Patent family member(s) | | | Publication date (day/month/year) |
|---|---|---|---|---|---|---|---|
| JP | 2019-119621 | A | 22 July 2019 | (Family: none) | | | |
| JP | 2010-111524 | A | 20 May 2010 | (Family: none) | | | |
| JP | 2003-95678 | A | 03 April 2003 | US | 2003/0012898 | A1 | |
| | | | | EP | 1319736 | A1 | |
| | | | | DE | 10231865 | A | |
| | | | | TW | 592945 | B | |
| | | | | KR | 10-2003-0007210 | A | |
| | | | | AT | 503865 | T | |
| WO | 2010/137221 | A1 | 02 December 2010 | US | 2011/0114530 | A1 | |
| | | | | EP | 2436658 | A1 | |
| | | | | CN | 102395535 | A | |
| | | | | KR | 10-2012-0022885 | A | |
| | | | | TW | 201111305 | A | |
| JP | 2012-136379 | A | 19 July 2012 | (Family: none) | | | |
| JP | 2020-100515 | A | 02 July 2020 | CN | 111334852 | A | |
| | | | | KR | 10-2020-0076636 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013140706 A1